# EUROPEAN PATENT APPLICATION

(11) **EP 4 811 954 A1**
(43) Date of publication of application: **23.09.2026**
(21) Application number: 26166246.4
(22) Date of filing: 19.03.2026
(51) Int. Cl.: H10D 8/01, H10D 8/00, H10D 89/60

(54) **TVS DIODE HAVING ASYMMETRIC BREAKDOWN VOLTAGE AND METHOD OF FORMATION**

(30) Priority: 21.03.2025 CN 202510350016
(71) Applicant: Littelfuse Semiconductor (Wuxi) Co., Ltd., Wuxi, Jiangsu 214142 (CN)
(72) Inventor: Zhou, Jifeng, Wuxi 214142 (CN); Gu, Xingchong, Wuxi 214142 (CN); Mou, Alex, Wuxi 214142 (CN); Chen, Hongfu, Wuxi 214142 (CN)
(74) Representative: Arnold & Siedsma

(57) **Abstract**

An asymmetric transient voltage suppression (TVS) device may include a semiconductor substrate, the semiconductor substrate comprising an inner region, having a first polarity, and a first surface region, disposed on a first surface of the semiconductor substrate, and comprising a second polarity, opposite the first polarity. The device may further include a second surface region, comprising the second polarity, and disposed on a second surface of the semiconductor substrate, opposite the first surface, wherein the first surface region comprises a first dopant concentration, the second surface region comprising a second dopant concentration, less than the first dopant concentration; and a first channel region, disposed adjacent to a perimeter of the first surface region, the first channel region comprising the second polarity, wherein the first channel region extends bellow the first surface to a channel depth that is greater than a first depth of the first surface region.

## Description

### BACKGROUND

### Field

The disclosure relates to the field of surge protection devices, and more particularly to transient voltage suppression devices.

### Discussion of Related Art

Transient voltage suppression devices (TVS) work to limit the voltage across a circuit, system or component to be protected. In particular, TVS devices include one or more diodes that act to clamp the voltage across a device or circuit at a maximum voltage that is set according to the design of the individual diode constituents of the TVS diodes. The voltage clamping may take place when a diode is subject to a voltage in excess of a breakdown voltage, where large current develops across the diode, limiting any increase in voltage. Asymmetric TVS devices may be constructed by providing two different diodes within a semiconductor die, where the different diodes are designed to clamp at different voltages. Thus, an asymmetric TVS diode provides bidirectional protection, where a component to be protected may operate in a designed voltage range in a positive voltage or negative voltage, while being protected against overvoltage in both positive and negative direction.

An asymmetric TVS device may thus be characterized by a high voltage side, where breakdown occurs at a relatively higher voltage, and a low voltage side, characterized by a relatively lower breakdown voltage. In present technology, the reliability of such asymmetric TVS devices may still merit further improvement. As an example, a low voltage side of an asymmetric TVS may be formed with a relatively higher dopant level and a relatively shallower P/N junction. In such structures, the device may be relatively more susceptible to edge termination defects.

With respect to these and other considerations, the present disclosure is provided.

### SUMMARY

An asymmetric transient voltage suppression (TVS) device is provided. The asymmetric TVS device may include a semiconductor substrate, the semiconductor substrate comprising an inner region, the inner region having a first polarity. The asymmetric TVS device may include a first surface region, disposed on a first surface of the semiconductor substrate, the first surface region comprising a second polarity, opposite the first polarity. The asymmetric TVS device may further include a second surface region, comprising the second polarity, and disposed on a second surface of the semiconductor substrate, opposite the first surface, wherein the first surface region comprises a first dopant concentration, and wherein the second surface region comprises a second dopant concentration, less than the first dopant concentration. The asymmetric TVS device may include a first channel region, disposed adjacent to a perimeter of the first surface region, the first channel region comprising the second polarity, wherein the first channel region extends bellow the first surface to a channel depth that is greater than a first depth of the first surface region.

A method of forming an asymmetric TVS device is provided. The method may include providing a semiconductor substrate, the semiconductor substrate comprising an inner region, the inner region having a first polarity and forming a first surface region on a first surface of the semiconductor substrate, the first surface region comprising a second polarity, opposite the first polarity. The method may also include forming a second surface region, comprising the second polarity, on a second surface of the semiconductor substrate, opposite the first surface, wherein the first surface region comprises a first dopant concentration, and wherein the second surface region comprises a second dopant concentration, greater than the first dopant concentration. The method may also include forming a first channel region, adjacent to a perimeter of the first surface region, the first channel region comprising the second polarity, wherein the first channel region extends bellow the first surface to a channel depth that is greater than a first depth of the first surface region.

An asymmetric transient voltage suppression (TVS) device is provided. The asymmetric TVS device may include a semiconductor substrate, the semiconductor substrate comprising an inner region, the inner region having a P type polarity and a first surface region, disposed on a first surface of the semiconductor substrate, the first surface region comprising a N type polarity. The asymmetric TVS device may also include a second surface region, comprising the N-type polarity, and disposed on a second surface of the semiconductor substrate, opposite the first surface, wherein the first surface region comprises a first dopant concentration, and wherein the second surface region comprises a second dopant concentration, less than the first dopant concentration. The asymmetric TVS device may further include a highly doped layer, disposed between the first surface layer and the inner layer, the highly doped layer comprising a P type polarity, and having a first dopant concentration that is greater than a second dopant concentration of the inner layer. The asymmetric TVS device may also include a first channel region, disposed adjacent to a perimeter of the first surface region, the first channel region comprising the N type polarity, wherein the first channel region extends bellow the first surface to a channel depth that is greater than a first depth of the first surface region.

### BRIEF DESCRIPTION OF DRAWINGS

**FIG. 1** depicts an asymmetric TVS device according to the disclosure;
**FIG. 2** depicts another asymmetric TVS device according to the disclosure;
**FIG. 3** depicts a further asymmetric TVS device according to the disclosure;
**FIG. 4** depicts an additional asymmetric TVS device according to the disclosure;
**FIG. 5A** depicts a side cross-sectional view of yet another TVS device according to the disclosure;
**FIG. 5B** depicts a top plan view of the TVS device of FIG. 5A;
**FIG. 6A** depicts a side cross-sectional view of still another TVS device according to the disclosure;
**FIG. 6B** depicts a top plan view of the TVS device of FIG. 6A;
**FIG. 7** depicts top plan view of a channel structure according to the disclosure ;
**FIG. 8** depicts top plan view of a channel structure according to the disclosure ;
**FIG. 9** depicts top plan view of a channel structure according to the disclosure ;
**FIG. 10** depicts an exemplary process flow; and
**FIG. 11** depicts another exemplary process flow.

### DETAILED DESCRIPTION

The disclosure provides architecture and techniques for synthesizing asymmetric TVS devices with improved properties.

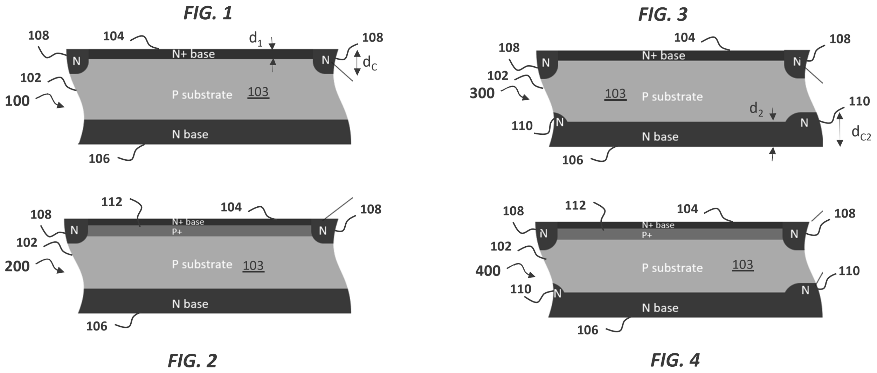

**FIG. 1** depicts an asymmetric TVS device 100 according to the disclosure. The asymmetric TVS device 100 is designed as a bidirectional asymmetric TVS device, where a low voltage side (upper surface in FIG. 1) is designed to clamp at a relatively lower voltage, while a high voltage side (lower surface) is designed to clamp at a relatively higher voltage. The asymmetric TVS device 100 includes a substrate 102, which substrate will have a first polarity, and may be formed of a doped monocrystalline semiconductor, such as silicon. For the purposes of illustration, the first polarity may be deemed to correspond to a P type substrate, where P/N junctions are formed on the low voltage side and high voltage side by the provision of N-type surface layers. It may be understood that the disclosure may cover TVS devices where the substrate has a first polarity that is N-type and the surface layers are P-type.

After completion of formation of the TVS device 100, as shown in FIG. 1, the semiconductor substrate has an inner region 103, that is bounded by further includes a first surface region 104, disposed on a first surface (the upper surface in FIG. 1) of the substrate 102, the first surface region 104 comprising a second polarity, opposite the first polarity. Following the convention in FIG. 1, the second polarity will be N-type.

The asymmetric TVS device 100 is further characterized by a second surface region 106, comprising the second polarity, and disposed on a second surface (the lower surface in FIG. 1) of the substrate 102, opposite the first surface. The first surface region 104 may be characterized by a first dopant concentration, and the second surface region 106 is characterized by a second dopant concentration, less than the first dopant concentration. Thus, the first surface region 104 may be designated as N+ base, while the second surface region 106 is designated as an N base.

The asymmetric TVS device 100 is also characterized by a first channel region 108, disposed adjacent to a perimeter of the first surface region 104. The first channel region 108 also is characterized as being of the second polarity, such as N-type. As illustrated, the first channel region 108 extends below the first surface (upper surface in FIG. 1) to a channel depth d_{c} that is greater than a first depth d₁ of the first surface region 104. The provision of the first channel region 108 may improve the reliability of the TVS device 100, and in particular may suppress edge termination defects.

Note that the first channel region 108 breakdown voltage is higher than N+ region, due to light doping. So when a device is working at this direction, the main leakage or current flows at the N+ region, not at the edge channel region. In this case, the device character is relatively not so sensitive to edge termination defects.

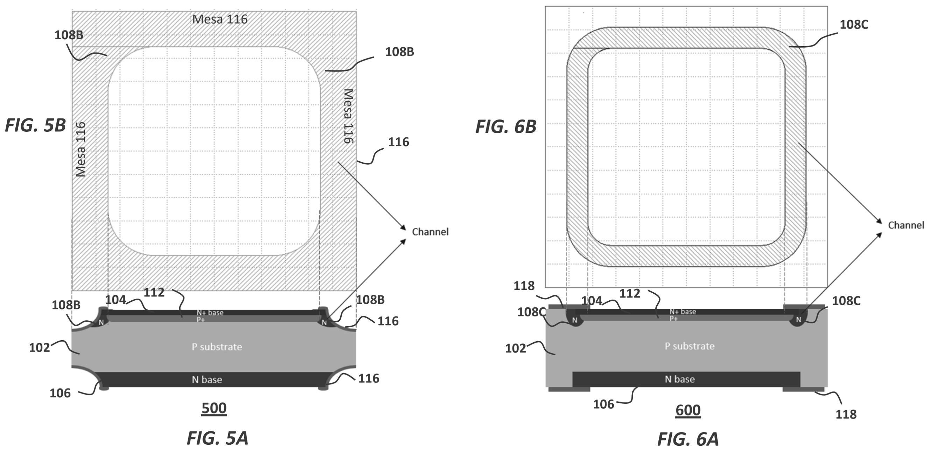

It may be understood that the first channel region 108 may surround the first surface region 104 in the main plane of the substrate 102, as detailed with respect to FIGs. 5A-9 to follow.

While the first channel region 108 may be deeper than the first surface region 104, the first channel region 108 need not be deeper than the first surface region 104, as long as the first channel region 108 overlaps with the first surface region 104 and is more lightly doped, thus exhibiting a higher breakdown voltage as compared to first surface region 104. It may be understood that an expedient manner to generate a less highly doped region is to drive dopants into a substrate to a greater depth, thus resulting in the relatively greater depth for the channel region 108.

**FIG. 2** depicts another asymmetric TVS device, shown as TVS device 200, according to the disclosure. The TVS device 200 may be designed similarly to TVS device 100, with like regions being labeled the same. A difference in the TVS device 200 with respect to TVS device 100, is the provision of a highly doped layer 112, adjacent to the first surface region 104. The highly doped layer 112 will have the same polarity as the substrate 102, such as a P+ layer, and is used to adjust the properties of the P/N diode formed with the first surface region 104. As with FIG. 1, the first surface region 104is relatively shallower, and the provision of the first channel region 108 will aid in improving resistance to edge termination defects.

**FIG. 3** depicts another asymmetric TVS device, shown as TVS device 300, according to the disclosure. The TVS device 300 may be designed similarly to TVS device 100, with like regions being labeled the same. A difference in the TVS device 300 with respect to TVS device 100, is the provision of a second channel region 110, disposed adjacent a perimeter of the second surface region 106. The second channel region 110 is characterized by having the second polarity, in the example shown, being N-type. Again, the second channel region 110 extends below the second surface (meaning into the substrate 102 from the lower surface in the figure) to a second channel depth d_{c2} that is greater than a second depth d₂ of second surface region 106. Thus, the TVS device 300 provides protection against edge termination defects on the high voltage side of the TVS device 300 (lower surface) as well as on the low voltage side.

**FIG. 4** depicts another asymmetric TVS device, shown as TVS device 400, according to the disclosure. The TVS device 400 may be designed similarly to TVS device 300, with like regions being labeled the same. A difference in the TVS device 400 with respect to TVS device 300, is the provision of the highly doped layer 112, adjacent to the first surface region 104. The highly doped layer 112 will have the same polarity as the substrate 102, such as a P+ layer, and is used to adjust the properties of the P/N diode formed with the first surface region 104, as discussed above. As with FIG. 2, the first surface region 104is relatively shallower, and the provision of the first channel region 108 will aid in improving resistance to edge termination defects, while the provision of the second channel region 110 provides additional resistance to edge termination defects.

For the purposes of illustration, and with reference to FIG. 2 or FIG. 4 in particular, Table I presents some exemplary features of a TVS device including some non-limiting values of such features.

**Table I.**

| **Features** | **Typical Range** |
|---|---|
| Raw silicon concentration (carrier/cm³) | 1E14 ^{~} 5E19/cm³ |
| Raw silicon thickness (um) | 200^{~}400 |
| N channel concentration (carrier/cm³) | 1E19 ^{~} 1.5E21/ cm³ |
| N channel depth (um) | 10 ^{~} 100 |
| Back N base concentration (carrier/cm³) | 1E19 ^{~}1.5E21/ cm³ |
| Back N base depth (um) | 5^{~} 80 |
| Top P+ concentration (carrier/cm³) | 1E15 ^{~} 3E20/ cm³ |
| Top P+ depth (um) | 5 ^{~} 50 |
| Top N+ base concentration (carrier/cm³) | 1E19 ^{~} 1.5E21/ cm³ |
| Top N+ base depth (um) | 2^{~} 40 |

As depicted in table I. the range of carrier concentration in the substrate, such as in inner region 103 may be in the range of 1E14 ^{~} 5E19/cm³. A wafer thickness for the TVS device may be in the order of 200 µm to 400 µm. In the case of a N-type channel formed on the low voltage side (and optionally on the high voltage side) the channel concentration may in the range of 1E19 1.5E21/ cm³ . A channel depth for the first channel may be in the range of 10 µm to 100 µm.

A concentration of the second surface layer (base layer for the high voltage diode) may be on the order of 1E19 ^{~}1.5E21/ cm³ N type dopant . The thickness of the second surface layer may be in the range of 5 µm to 80 µm. A concentration of the highly doped layer (e.g., P⁺ layer for the low voltage diode) may be on the order of 1E15 ^{~}3E20/ cm³ N type dopant. The thickness of the highly doped layer may be in the range of 5 µm to 50 µm. A concentration of the first surface layer (e.g., N layer for the low voltage diode) may be on the order of 1E19 ^{~}1.5E21/ cm³ N type dopant.

By adjusting the dopant concentration and thickness in the various regions, as outlined in Table I, the properties of P/N diodes formed in an asymmetric TVS device may be adjusted accordingly. Table II presents examples of device properties for four exemplary TVS devices, arranged according to the disclosure. A first device, labeled PN1, exhibits a high voltage side stand off voltage of 15 V, minimum breakdown voltage of 16.7 V and maximum breakdown voltage of 18.5 V. The low voltage side exhibits a standoff voltage of 5 V, with a minimum breakdown voltage of 6.82 V and maximum breakdown voltage of 7.48 V.

A second device, labeled PN2, exhibits a high voltage side stand off voltage of 19 V, minimum breakdown voltage of 21.1 V and maximum breakdown voltage of 23.3 V. The low voltage side exhibits a standoff voltage of 5 V, with a minimum breakdown voltage of 6.82 V and maximum breakdown voltage of 7.48 V.

A third device, labeled PN3, exhibits a high voltage side stand off voltage of 24 V, minimum breakdown voltage of 26.6 V and maximum breakdown voltage of 29.4 V. The low voltage side exhibits a standoff voltage of 12 V, with a minimum breakdown voltage of 13.3 V and maximum breakdown voltage of 14.7 V.

A fourth device, labeled PN4, exhibits a high voltage side stand off voltage of 36 V, minimum breakdown voltage of 40 V and maximum breakdown voltage of 44.2 V. The low voltage side exhibits a standoff voltage of 16 V, with a minimum breakdown voltage of 17.8 V and maximum breakdown voltage of 19.7 V.

Note that in experimental results, for an asymmetric TVS wafer fabricated without the channel structure, a low probe yield was observed at the low voltage side due to bad edge termination, while yield was improved after adding the channel structure.

**Table II.**

| **PN** | **High Voltage Side** | | | **Low Voltage Side** | | |
|---|---|---|---|---|---|---|
| | **Stand off voltage V_{R1} (V)** | **Breakdown Voltage V_{BR1} (V)** | | **Stand off voltage V_{R2} (V)** | **Breakdown Voltage V_{BR2} (V)** | |
| | | **Min** | **Max** | | **Min** | **Max** |
| PN1 | 15 | 16.7 | 18.5 | 5 | 6.82 | 7.48 |
| PN2 | 19 | 21.1 | 23.3 | 5 | 6.82 | 7.48 |
| PN3 | 24 | 26.6 | 29.4 | 12 | 13.3 | 14.7 |
| PN4 | 36 | 40.0 | 44.2 | 16 | 17.8 | 19.7 |

**FIG. 5A** depicts a side cross-sectional view of yet another TVS device according to the disclosure. **FIG. 5B** depicts a top plan view of the TVS device of FIG. 5A. The TVS device 500 may be designed similarly to TVS device 200, with like regions being labeled the same. A difference in the TVS device 500 with respect to TVS device 200, is the provision of recess regions 116, on both the upper surface and lower surface of the substrate 102. The recess regions 116 may include etched substrate recesses, and passivation, covering the etch substrate recesses, that impart a mesa structure to the TVS device 500. As shown in FIG. 5B, the channel region 108B may form a rectangular boundary around the first surface region 104 (N+ base in this figure).

The first surface region 104 may have a rectangular shape, a hexagonal shape, an elliptical shape, or an oval shape.

As further shown in FIG. 5A, the channel region 108B may be disposed adjacent to the highly doped layer 112 and subjacent to the first surface region 104. As further shown in FIG. 5A, the recess regions 116 may extend to a greater depth from the first surface of the substrate 102 than a depth of the channel region 108B. Note that the channel region 108B may be formed before mesa etch is conducted. In the particular chip structure FIG.5A, a N+ base photolithography and etch process may be skipped where the N+ base (first surface region 104) is formed globally, while still having a channel structure (channel region 108B) and the advantages provided by the channel structure. The Mesa etch region (recess regions 116) provides an edge termination to protect a PN junction after dicing of the substrate to form individual chips. Note that it is necessary to form the recess regions 116 to a deeper depth than the channel region 108B and deeper than the first surface region 104. Only in this case, is the channel-sub NP junction edge passivated after being diced into chips. The same applies to passivation of the backside, meaning second surface region 106.

**FIG. 6A** depicts a side cross-sectional view of still another TVS device according to the disclosure. **FIG. 6B** depicts a top plan view of the TVS device 600 of FIG. 6A. The TVS device 600 may be designed similarly to TVS device 200, with like regions being labeled the same. The TVS device 600 may be considered to be a variant of TVS device 200, where the first channel region 108C has a square racetrack shape, a shown in FIG. 6B. The TVS device 600 also includes passivation layers 118, above the periphery of the first surface region 104 and second surface region 106.

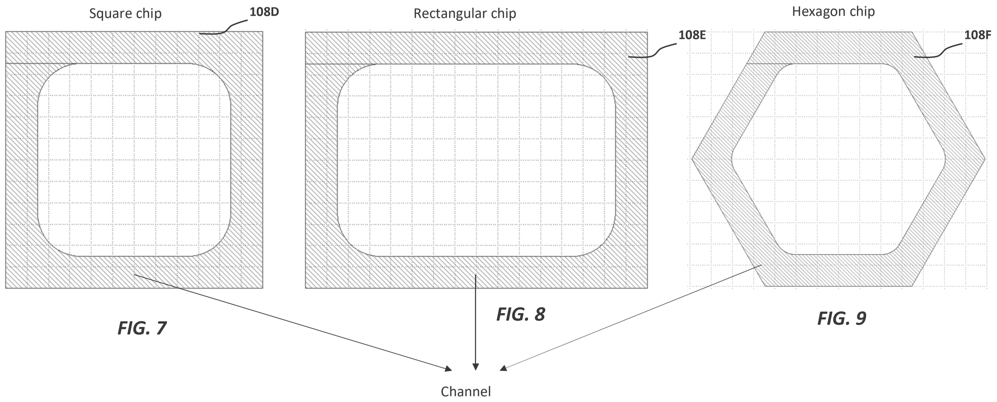

**FIG. 7** depicts top plan view of a channel structure 108D. In this example, the channel structure 108D defines a square shape, suitable as a border region for a square semiconductor chip.

**FIG. 8** depicts top plan view of a channel structure 108E . In this example, the channel structure 108E defines an elongated rectangular shape, suitable for a rectangular semiconductor chip.

**FIG. 9** depicts top plan view of a channel structure. In this example, the channel structure 108F has a hexagonal shape. Note that In some packages, hexagon chips are more suitable for multiple chip stacking assembly. Then the channel structure 108F with a hexagonal shape will be suitable for such a hexagonal chip.

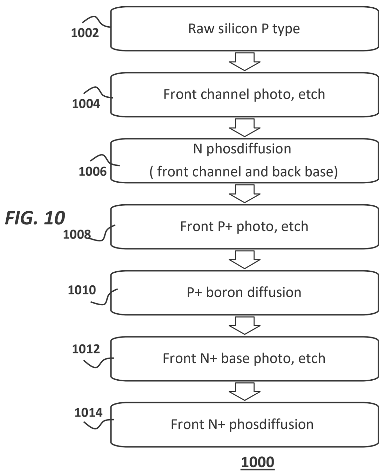

**FIG. 10** depicts an exemplary process flow 1000, according to the disclosure. At block 1002, a substrate is provided. In one example, the substrate is P-type silicon semiconductor wafer.

At block 1004, a lithography process is provided to define a first channel region on a first surface of the substrate. This surface may be deemed the low voltage side of a device to be formed. The lithography process may include lithographic exposure of a patterning layer that is formed just on the first surface of the substrate in order to define the first channel region. This lithographic exposure may be followed by selective etching of the patterning layer to define an exposed region on the first surface of the substrate, corresponding to the channel region to be formed. The exposed region may have a shape in plan view that is suitable for a diode shape to be formed, such as a square ring shape, a rectangular ring shape, a hexagonal ring shape, and so forth.

At block 1006, a channel diffusion process is performed to form the first channel region. Note that the first surface of the substrate may be covered by a patterned mask (the first patterning layer) during the channel diffusion process, so that just the first channel region is exposed to ambient. As an example, the channel diffusion process may involve exposure to a phosphorous-containing species at elevated temperature, to form a N type channel.

Advantageously, the second surface of the substrate, opposite the first surface, may be uncovered during this channel diffusion process, so that the channel diffusion process acts to form a surface layer of a dopant of opposite polarity to the substrate, such as an N type surface layer in the case of a P type substrate.

At block 1008, an enhanced doped layer formation lithography process is performed to define a low voltage diode on a front side of the substrate. The lithography process may involve patterning a pattering layer in a diode region on the first surface of the substrate that is located within ring shape defined by the first channel region. After lithographic exposure, the patterning layer may be etched to expose the first surface of the substrate in an area corresponding to the diode region, such as a square area, rectangular area, and so forth.

At block 1010, an enhanced doped layer diffusion process is performed. The diode diffusion process may involve exposure to a boron-containing species at elevated temperature, to form a P+ surface layer, that has a depth that is shallower than the depth of N dopant in the channel region that surrounds the P+ surface layer. Note that the second surface of the substrate may be covered to prevent exposure to the P-dopant during this operation.

At block 1012, a low-voltage-diode-formation lithography process is performed to complete the definition of the low voltage diode on the front side of the substrate. The lithography process may involve patterning a pattering layer in a diode region on the first surface of the substrate that is located within ring shape defined by the first channel region. After lithographic exposure, the patterning layer may be etched to expose the first surface of the substrate in an area corresponding to the diode region, such as a square area, rectangular area, and so forth. In some examples. the exposed area in the operation of block 1012 may essentially overlap the area exposed in block 1008.

At block 1014, a diode diffusion process is performed. The diode diffusion process may involve exposure to a phosphorous-containing species at elevated temperature, to form a N+ surface layer, that has a depth that is shallower than the depth of N dopant in the channel region that surrounds the N+ surface layer. The N+ surface layer may compensate any p-type dopant from the initial substrate and from the formation of the P+ layer, such that the N+ layer is disposed at the outer surface of the substrate, above the P+ layer. Note that the second surface of the substrate may be covered to prevent exposure to the N-dopant during this operation.

According to the disclosure, the flow sequence of some of the operations of exemplary process flow 1000 may be changed. In some cases the N channel diffusion (or second layer formation ( N base diffusion)) and top side P+ diffusion (enhanced doped layer diffusion) may exchange relative positions in the flow sequence.

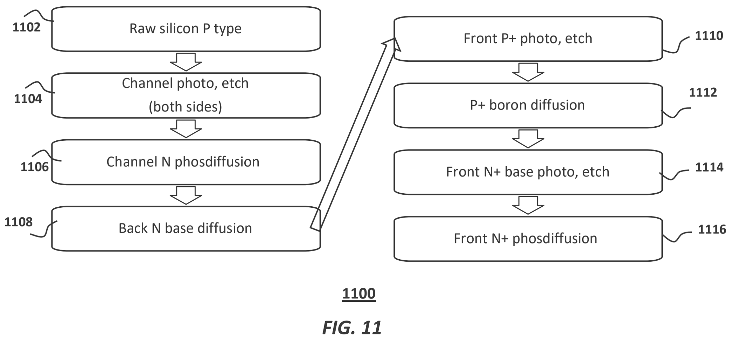

**FIG. 11** depicts another exemplary process flow 1100. At block 1102, a substrate is provided. In one example, the substrate is P-type silicon semiconductor wafer.

At block 1104, a set of lithography processes are performed to define a first channel region on a first surface of the substrate, and a second channel region on a second surface of the substrate. The set of lithography processes may include lithographic exposure of two separate patterning layers that are formed on the first surface of the substrate, and the second surface of the substrate, in order to define the first channel region and the second channel region, respectively. This lithographic exposure of the two patterning layers may be followed by selective etching of the two patterning layers to define a first exposed region on the first surface of the substrate and a second exposed region on the second surface of the substrate, corresponding to the channel region to be formed, and the second channel region to be formed, respectively. The first exposed region and the second exposed region may have a shape in plan view that is suitable for a diode shape to be formed, such as a square ring shape, a rectangular ring shape, a hexagonal ring shape, and so forth.

At block 1106, a channel diffusion process is performed to form the first channel region and the second channel region. Note that the first surface of the substrate and the second surface of the substrate may each be covered by a patterned mask (first patterning layer and the second patterning layer) during the channel diffusion process, so that just the first channel region and the second channel region are exposed to ambient. As an example, the channel diffusion process may involve exposure to a phosphorous-containing species at elevated temperature, to form a N type channel.

Advantageously, the channel diffusion process may be performed simultaneously on both first surface and the second surface.

At block 1108, a base diffusion process is performed to form a second surface layer on the second side of the substrate. At this stage, the patterning layer from the second surface may be removed, while the front surface is covered by a protecting layer so that the entire surface of the second surface is exposed to a dopant, such as N-type dopant, while the front surface is not exposed to dopant.

At block 1110, an enhanced doped layer formation lithography process is performed to define a low voltage diode on a front side of the substrate. The lithography process may involve patterning a pattering layer in a diode region on the first surface of the substrate that is located within ring shape defined by the first channel region. After lithographic exposure, the patterning layer may be etched to expose the first surface of the substrate in an area corresponding to the diode region, such as a square area, rectangular area, and so forth.

At block 1112, an enhanced doped layer diffusion process is performed. The diode diffusion process may involve exposure to a boron-containing species at elevated temperature, to form a P+ surface layer, that has a depth that is shallower than the depth of N dopant in the channel region that surrounds the P+ surface layer. Note that the second surface of the substrate may be covered to prevent exposure to the P-dopant during this operation.

At block 1114, a low-voltage-diode-formation lithography process is performed to complete the definition of the low voltage diode on the front side of the substrate. The lithography process may involve patterning a pattering layer in a diode region on the first surface of the substrate that is located within ring shape defined by the first channel region. After lithographic exposure, the patterning layer may be etched to expose the first surface of the substrate in an area corresponding to the diode region, such as a square area, rectangular area, and so forth. In some examples. the exposed area in the operation of block 1114 may essentially overlap the area exposed in block 1106.

At block 1116, a diode diffusion process is performed. The diode diffusion process may involve exposure to a phosphorous-containing species at elevated temperature, to form a N+ surface layer, that has a depth that is shallower than the depth of N dopant in the channel region that surrounds the N+ surface layer. The N+ surface layer may compensate any p-type dopant from the initial substrate and from the formation of the P+ layer, such that the N+ layer is disposed at the outer surface of the substrate, above the P+ layer. Note that the second surface of the substrate may be covered to prevent exposure to the N-dopant during this operation.

According to the disclosure, the flow sequence of some of the operations of exemplary process flow 1100 may be changed. In some cases the N channel diffusion (or second layer formation ( N base diffusion)) and top side P+ diffusion (enhanced doped layer diffusion) may exchange relative positions in the flow sequence.

## Claims

1. An asymmetric transient voltage suppression (TVS) device, comprising:
a semiconductor substrate, the semiconductor substrate comprising an inner region, the inner region having a first polarity;
a first surface region, disposed on a first surface of the semiconductor substrate, the first surface region comprising a second polarity, opposite the first polarity;
a second surface region, comprising the second polarity, and disposed on a second surface of the semiconductor substrate, opposite the first surface,
wherein the first surface region comprises a first dopant concentration, and wherein the second surface region comprises a second dopant concentration, less than the first dopant concentration; and
a first channel region, disposed adjacent to a perimeter of the first surface region, the first channel region comprising the second polarity, wherein the first channel region extends bellow the first surface to a channel depth that is greater than a first depth of the first surface region.

2. The asymmetric TVS device of claim 1, wherein the first surface region defines a low voltage side of the semiconductor substrate.

3. The asymmetric TVS device of claim 1 or 2, wherein the semiconductor substrate comprises a p-type substrate, and wherein the first surface region and the second surface region comprise n-type regions.

4. The asymmetric TVS device of any of the preceding claims ,further comprising a second channel region, disposed adjacent a perimeter of the second surface region, the second channel region comprising the second polarity, wherein the second channel region extends below the second surface to a second channel depth that is greater than a second depth of the second surface region.

5. The asymmetric TVS device of any of the preceding claims, wherein the first surface region has a rectangular shape, a hexagonal shape, an elliptical shape, or an oval shape, and/or
wherein the semiconductor substrate comprises a n-type substrate, and wherein the first surface region and the second surface region comprise p-type regions.

6. The asymmetric TVS device of any of the preceding claims, further comprising a highly doped layer, disposed between the first surface region and the inner region, the highly doped layer comprising a dopant of the first polarity, and having a first dopant concentration that is greater than a second dopant concentration of the inner layer.

7. The asymmetric TVS device of any of the preceding claims , further comprising a recess region, disposed circumferentially around the first channel region, wherein the recess region extends to a greater depth from the first surface, as compared to the channel depth the first channel, preferably further comprising a second recess region, disposed circumferentially around the second surface region and extending to a deeper depth from the second surface as compared to a second depth of the second surface region.

8. A method of forming an asymmetric TVS device, comprising:
providing a semiconductor substrate, the semiconductor substrate comprising an inner region, the inner region having a first polarity;
forming a first surface region on a first surface of the semiconductor substrate, the first surface region comprising a second polarity, opposite the first polarity;
forming a second surface region, comprising the second polarity, on a second surface of the semiconductor substrate, opposite the first surface,
wherein the first surface region comprises a first dopant concentration, and wherein the second surface region comprises a second dopant concentration, greater than the first dopant concentration; and
forming a first channel region, adjacent to a perimeter of the first surface region, the first channel region comprising the second polarity, wherein the first channel region extends bellow the first surface to a channel depth that is greater than a first depth of the first surface region.

9. The method of claim 8, wherein the forming the first surface region takes place separately from forming the second surface region, an/or
wherein the second surface region is formed concurrently with formation of the first channel region.

10. The method of claim 8 or 9, further comprising forming a second channel region, adjacent a perimeter of the second surface region, the second channel region comprising the second polarity, wherein the second channel region extends bellow the second surface to a channel depth that is greater than a second depth of the second surface region.

11. The method of any of the claims 8-10, wherein the semiconductor substrate comprises a n-type substrate, and wherein the first surface region and the second surface region comprise p-type regions.

12. The method of any of the claims 8-11, further comprising forming a highly doped layer, disposed between the first surface region and the inner region, the highly doped layer comprising a dopant of the first polarity, and having a first dopant concentration that is greater than a second dopant concentration of the inner layer.

13. The method of any of the claims 8-12, further comprising forming a recess region, circumferentially around the first channel region, wherein the recess region extends to a greater depth from the first surface, as compared to the channel depth the first channel, preferably
further comprising forming a second recess region, circumferentially around the second surface region and extending to a deeper depth from the second surface as compared to a second depth of the second surface region.

14. An asymmetric transient voltage suppression (TVS) device, comprising:
a semiconductor substrate, the semiconductor substrate comprising an inner region, the inner region having a P type polarity;
a first surface region, disposed on a first surface of the semiconductor substrate, the first surface region comprising a N type polarity;
a second surface region, comprising the N-type polarity, and disposed on a second surface of the semiconductor substrate, opposite the first surface,
wherein the first surface region comprises a first dopant concentration, and wherein the second surface region comprises a second dopant concentration, less than the first dopant concentration;
a highly doped layer, disposed between the first surface region and the inner region, the highly doped layer comprising a P type polarity, and having a first dopant concentration that is greater than a second dopant concentration of the inner region; and
a first channel region, disposed adjacent to a perimeter of the first surface region, the first channel region comprising the N type polarity, wherein the first channel region extends bellow the first surface to a channel depth that is greater than a first depth of the first surface region.

15. The asymmetric TVS device of claim 14, further comprising a second channel region, disposed adjacent a perimeter of the second surface region, the second channel region comprising the N type polarity, wherein the second channel region extends below the second surface to a second channel depth that is greater than a second depth of the second surface region.
